# EUROPEAN PATENT APPLICATION

(11) **EP 2 023 413 A1**
(43) Date of publication of application: **11.02.2009**
(21) Application number: 07744304.2
(22) Date of filing: 29.05.2007
(51) Int. Cl.: H01L 33/00, H01L 23/12

(54) **ELECTRONIC COMPONENT AND METHOD FOR MANUFACTURING SAME**

(30) Priority: 31.05.2006 JP 2006150903
(71) Applicant: Sanyo Electric Co., Ltd., Osaka 570-8677 (JP); Matsuoka, Yoichi, Izumi-Shi, Osaka 594-0041 (JP)
(72) Inventor: MATSUOKA, Yoichi, Izumi-Shi Osaka 594-0041 (JP); NAKAHARA, Toshinori c/o Sanyo Electric CO., LTD., Osaka 5708677 (JP); TAKIGAWA, Keiko c/o Sanyo Electric CO., LTD., Osaka 5708677 (JP); MATSUMOTO, Akihisa c/o Sanyo Electric CO., LTD., Osaka 5708677 (JP)
(74) Representative: Glawe, Delfs, Moll
(86) International application number: PCT/JP2007/060884
(87) International publication number: WO 2007/139098

(57) **Abstract**

In an electronic component (1), a frame (3) composed of a conductor is fixed on a circumference portion on the upper surface of a circuit board (2). The circuit board (2) and the frame (3) have a side surface (41) composed of a same surface, and the circuit board (2) is provided with terminal sections (16, 17) exposed on the side surface (41). The frame (3) has an empty space (22) over a lower surface facing the circuit board (2) and a side surface (20). The empty space (22) may be filled with an insulating material.

## Description

### Technical Field of the Invention

The present invention relates to an electronic component having a frame fixed on the upper surface of a circuit board and a method for manufacturing same, and more specifically to an electronic component suitable for a surface-mounted LED used as a light source for switch internal illumination, an LED display, a backlight light source, an optical printer head, a camera flash, or the like and to a method for manufacturing same.

### Background Art

Patent Document 1 discloses a surface-mounted LED as a conventional electronic component. FIG. 8 is a sectional view showing this surface-mounted LED. The surface-mounted LED has electrodes 102 and 103 provided on the upper surface side and lower surface side of an insulating substrate 101. The electrodes 102 and 103 are connected to each other by a through hole 104. Below an opening of the insulating substrate 101, an electrode 105 is provided, which is mounted with an LED element 106 with a conducting material. The front side electrode of the LED element 106 and the electrode 102 are connected together with a thin metal wire 107.

On the circumference portion of the surface-mounted LED, a reflective frame 108 as a frame is provided. The reflective frame 108 is typically formed of an insulating material as a resin material, and is fixed on the electrodes 102 and 105 on the insulating substrate 101 with an adhesive 110. In the opening part of the reflective frame 108, a translucent resin 109 is filled. This encapsulates the LED element 106 and the thin metal wire 107.

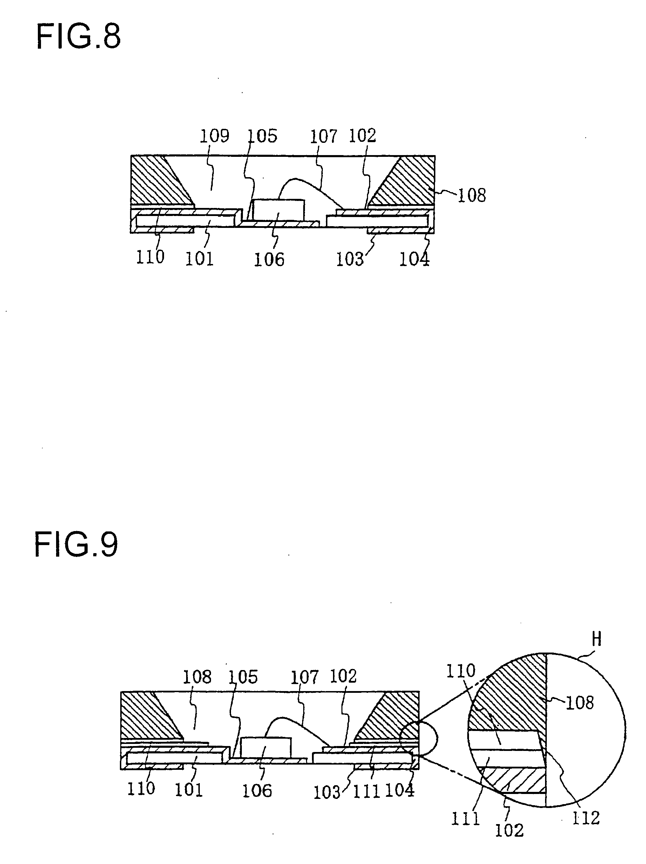

Moreover, a surface-mounted LED is known which has the reflective frame 108 formed of a metal component for heat radiation. This surface-mounted LED, as shown in FIG. 9, has an insulating film 111 provided on the surfaces of 102 and 105 for the purpose of preventing short circuit of polar electrodes.

[Patent Document 1] JP-A-H7-235696 (FIG. 8)

### Disclosure of the Invention

### Problems to be Solved by the Invention

An electronic component of this type is manufactured by first forming a plurality of elements on one board and separating them into individual components by a dicing device such as a dicing saw. As shown by an H section of FIG. 9, the reflective frame 108 divides the electronic component composed of a metal member into individual components with a dicing saw, thereby causing metal burr (chip) 112 at the bottom of the reflective frame 108. Contact of this burr 112 with the polar electrodes 102 and 105 leads to formation of a short circuit in an electric circuit.

It is an object of the invention to provide an electronic component that can prevent formation of a short circuit by a frame including a metal material.

### Means for Achieving the Object

To achieve the object described above, the present invention refers to an electronic component having a frame fixed on a circumference portion on an upper surface of a circuit board, in which the circuit board and the frame have a side surface composed of a same surface, in which the circuit board has a terminal section exposed on the side surface, and in which the frame has an empty space over a lower surface facing the circuit board and the side surface.

With this configuration, the frame fixed on the circuit board and the terminal section formed on the surface of the circuit board are arranged on a side surface of the electronic component where the terminal section is exposed in such a manner as to be separated by the empty space. As a result, short circuit between the terminal section and the frame due to burr generated by cutting when the frame is formed of metal is avoided by the empty space. Moreover, when an insulating substrate forming the circuit board is slimmed down, insulation failure as a result of soldering can be prevented by making the height (depth) of the empty space higher than the height of soldering paste used for fixing the circuit board.

Moreover, the invention refers to the electronic component with the configuration described above, in which the terminal section is formed on a surface of the circuit board on a side separated from the frame.

Moreover, the invention refers to the electronic component with the configuration described above, in which a coating material composed of an insulating body is filled in the empty space.

Moreover, the invention refers to the electronic component with the configuration described above, in which the frame has a surface facing the empty space, the surface being covered by a coating material having a higher degree of hardness than the frame and a predetermined thickness.

Moreover, the invention refers to the electronic component with the configuration described above, in which the coating material is formed by subjecting the frame to chemical conversion treatment. With this configuration, when the frame is composed of, for example, aluminum, the surface of the empty space is covered by alumite formed by alumite processing.

Moreover, the invention refers to the electronic component with the configuration described above, including a surface-mounted LED which has an LED element arranged inside surrounded by the frame and which reflects emitted light of the LED element by the frame.

Moreover, the invention refers to a method for manufacturing an electronic component. The method includes: a process of supplying a circuit board aggregate where a plurality of circuit boards having a terminal section of an electrode are formed; a process of forming a frame aggregate having a plurality of frames; a process of fixing the circuit board aggregate and the frame aggregate; and a process of cutting and dividing the fixed circuit board aggregate and frame aggregate on the frames and the terminal sections, in which a process of forming, on a side of the frame facing the circuit board aggregate, a groove extending along cut surfaces of the circuit board aggregate and the frame aggregate and having a wider width than a cutting width is provided before the process of fixing the circuit board aggregate and the frame aggregate.

With this configuration, the circuit board aggregate is formed with a plurality of circuit boards, and the frame aggregate is formed with a plurality of frames. On one surface of the frame, a groove is formed, and the frame aggregate is fixed to the circuit board aggregate with the groove facing the circuit board aggregate. The integrated frame aggregate and circuit board aggregate are divided into a plurality of frames and circuit boards by cutting on the groove with a dicing saw or the like. On the cut surface of the circuit board, the terminal section is exposed in the same plane as the cut surface of the frame. Moreover, since the groove width is wider than the cutting margin, the empty space is formed by the groove remaining between the lower surface of the frame facing the circuit board and the cut surface. Within the cut surface, the frame and the terminal section are arranged in such a manner as to be separated by the empty space. As a result, short circuit between the terminal section and the frame due to burr generated through cutting when the frame is composed of metal is avoided by the empty space.

Moreover, the invention refers to the method for manufacturing an electronic component with the configuration described above. The method further includes a process of filling in the groove with a coating material composed of an insulating body.

Moreover, the invention refers to the method for manufacturing an electronic component with the configuration described above. The method further includes a process of covering a surface of the groove with a coating material having a higher degree of hardness than the frame and a predetermined thickness.

### Advantages of the Invention

According to the present invention, since the frame has the empty space over the lower surface of the frame facing the circuit substrate and the side surface thereof, formation of short circuit attributable to metal burr when the frame includes a metal material can be prevented. Therefore, operation of the electronic component can be stabilized. Moreover, when the circuit board is fixed at a place where the insulating substrate of the circuit board becomes thin and soldering paste is applied, insulation failure as a result of soldering can be prevented by providing an empty space higher than the thickness of the soldering paste.

Moreover, according to the invention, the terminal section is formed on a surface of the circuit board on the side separated from the frame, the terminal section and the frame can be so arranged as to be more separated from each other. Therefore, short circuit due to metal burr can be reliably avoided.

According to the invention, since the coating material composed of an insulating body is filled in the empty space, performance in insulation between the terminal section and the frame can be improved and also occurrence of metal burr can be more reduced.

According to the invention, since the surface of the frame facing the empty space is covered by the coating material having higher degree of hardness than the frame and a predetermined thickness, the occurrence of metal burr can be more reduced.

According to the invention, since the coating material is formed by subjecting the frame to chemical conversion treatment, a coating material having higher degree of hardness than the frame can easily be formed.

### Brief Description of the Drawings

[FIG. 1] is a perspective sectional view showing an electronic component of a first embodiment of the present invention.
[FIG. 2] is a top view showing the electronic component of the first embodiment of the invention.
[FIG. 3] is a bottom view showing the electronic component of the first embodiment of the invention.
[FIG. 4] is a bottom view of the electronic component of the first embodiment of the invention with coating omitted.
[FIG. 5] is a process diagram showing one example of a method for manufacturing the electronic component of the first embodiment of the invention.
[FIG. 6] is a perspective sectional view showing an electronic component of a second embodiment of the invention.
[FIG. 7] is a perspective sectional view showing an electronic component of a third embodiment of the invention.
[FIG. 8] is a sectional view showing a conventional electronic component.
[FIG. 9] is a sectional view showing another conventional electronic component.

### Lists of Reference Symbols

- 1: Surface-mounted LED
- 2: Circuit board
- 3: Frame
- 4: Electrode (nonpolar)
- 5, 6: Electrodes (polar)
- 7, 106: LED elements
- 8, 9, 107: Thin metal wires
- 10: opening
- 11: Transmissive resin
- 12: Insulating substrate
- 13, 14: Through holes
- 15: Electrode (for heat radiation)
- 16, 17: Electrodes (for wiring)
- 18: Depression
- 19: Coating
- 20: Side surface
- 21: Cut surface
- 22: Empty space
- 23: Coating material
- 24: Insulating layer
- 25: Adhesive
- 26: Aluminum thin plate
- 27: Frame aggregate
- 28: Groove
- 29: Board aggregate
- 30: Dicing saw
- 41: Side surface

### Best Mode for Carrying Out the Invention

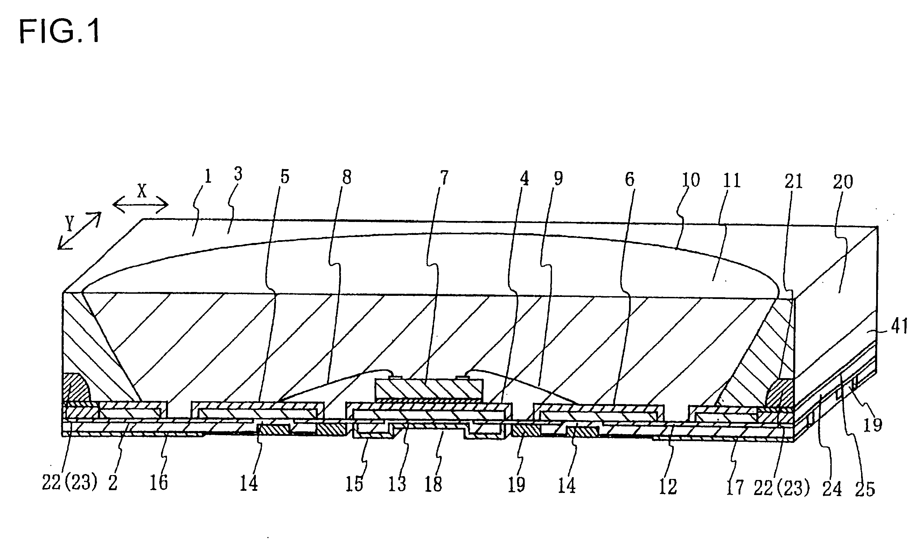

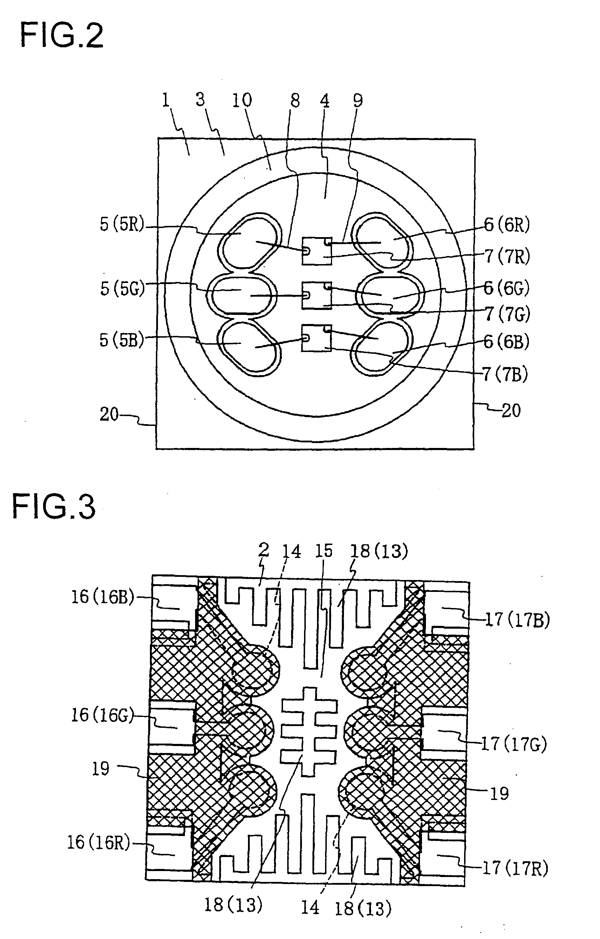

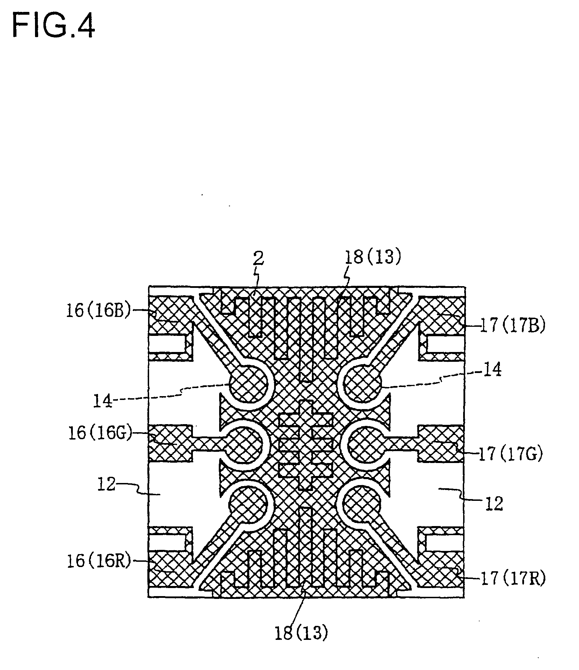

Hereinafter, the embodiments of the present invention will be described with reference to the accompanying drawings. FIG. 1 is a perspective sectional view showing a surface-mounted LED (light-emitting diode) 1 as an electronic component of a first embodiment. FIG. 2 is a top view showing a state of the surface-mounted LED 1 with transmissive resin 11 omitted. FIG. 3 is a bottom view showing the surface-mounted LED 1. FIG. 4 is a bottom view showing a state of FIG. 3 with coating 19 (hatched portions) omitted.

The surface-mounted LED 1 is structured to have a frame 3 fixed on the upper surface of a circuit board 2. The frame 3 has an opening 10 vertically penetrating therethrough, and is disposed on the circumference portion of the circuit board 2. In the opening 10, a nonpolar electrode 4 and polar electrodes 5 and 6 are disposed. The electrodes 4, 5, and 6 are formed on the upper surface side of an insulating substrate 12 of the circuit board 2. The electrode 5 has either of positive or negative polarities, while the electrode 6 has the other polarity. The electrode 5 has electrodes 5R, 5G, and 5B respectively in correspondence with a plurality of LED elements 7 to be described later. The electrode 6 has electrodes 6R, 6G, and 6B respectively in correspondence with the LED elements 7. The electrode 4 is electrically separated from the electrodes 5 and 6 and is nonpolar (neutral), having no polarity.

The plurality of electrodes (5R, 5G, and 5B) and 6 (6R, 6G, and 6B) respectively having positive and negative polarities are arranged on the upper surface of the circuit board 2 inside the opening 10 of the frame 3. The nonpolar electrode 4 is arranged in a region other than the electrodes 5 and 6 inside the opening 10 of the frame 3, and is also arranged between the lower surface of the frame 3 and the circuit board 2. That is, the electrode 4 is formed to extend over a wide range in such a manner as to cover almost the entire upper surface of the circuit board 2 excluding the electrodes 5 and 6 and insulating grooves therearound.

On the nonpolar electrode 4, an LED element 7 as a circuit element is loaded. One electrode of the LED element 7 is connected to the polar electrode 5 with a thin metal wire 8. The other electrode of the LED element 7 is connected to the polar electrode 6 with a thin metal wire 9. The opening 10 is filled with transmissive resin 11, which seals the LED element 7 and the thin metal wires 8 and 9.

In the insulating substrate 12 of the circuit board 2, a through hole 13 is provided below the electrode 4, and through holes 14 are provided below the electrodes 5 and 6. On the lower surface side of the insulating substrate 12, electrodes 15, 16, and 17 are formed. The electrode 16 has electrodes 16R, 16G, and 16B respectively in correspondence with the LED elements 7. The electrode 17 has electrodes 17R, 17G, and 17B respectively in correspondence with the LED elements 7. The electrodes 4 and 15 are connected together via the through hole 13. The electrodes 5R, RG, and 5B and the electrodes 16R, 16G, and 16B are connected together via the through hole 14. Moreover, the electrodes 6R, 6G, and 6B and the electrodes 17R, 17G, and 17B are connected together via the through hole 14.

FIG. 4 shows by cross-hatching the electrodes 16 (16R, 16G, and 16B) and 17 (17R, 17G, and 17B) connected to the polar electrodes 5 and 6 and the electrode 15 connected to the nonpolar electrode 4. The electrodes 16 (16R, 16G, and 16B) and 17 (17R, 17G, and 17B) connected to the polar electrodes 5 and 6 are mainly for wiring and function as polar electrodes. The electrode 15 connected to the nonpolar electrode 4 is mainly for heat radiation and functions as a nonpolar electrode.

On the electrode 15 for heat radiation, a depression 18 is formed on which a planar shape of the through hole 13 provided in the insulating substrate 12 is reflected. With the depression 18, a geometric pattern is formed on the rear surface of the circuit board 2. The electrode 15 for heat radiation is directly connected to the nonpolar electrode 4 via a large number of through holes 13, thus permitting heat generated at the LED elements 7 to be efficiently radiated via the electrode 15 for heat radiation. Since this promotes heat radiation of the LED elements 7, deterioration in light emission efficiency due to temperature increase of the LED elements 7 decreases, permitting providing high brightness proportional to the amount of current. Therefore, effect of improving the functionality of the surface-mounted LED 1 and improving the life can be provided.

The electrodes 16 and 17 for wiring excluding terminal sections are, as shown in FIG. 3, coated with the insulating coating 19. The electrode 15 for heat radiation can be partially coated with the insulating coating 19, but, for the purpose of increasing heat radiation performance, is all exposed without being coated with the insulating coating 19.

The terminal sections of the electrodes 16 and 17 for wiring are fixed to terminal sections of a different circuit board with a conducting material such as solder. The electrode 15 for heat radiation is also fixed to a terminal section or a heat sink section of a different circuit board with a conducting material such as solder.

The frame 3 is formed of a material having excellent heat conductivity, and aluminum is used in this embodiment, but magnesium or any other metal material can also be used. Moreover, instead of a metal material, a member having a resin surface or a ceramic surface coated with a metal material, a member having a plurality of metal materials or ceramic materials coupled together with an adhesive material such as resin or metal, a member having metal dispersed in resin, or the like can also be used.

The side surface 41 of the surface-mounted LED 1 on the side on which the terminal sections of the electrodes 16 and 17 are exposed is, as shown in FIG. 1, composed of the same surface as the side surface 20 of the frame 3, and at the lower section of the frame 3, empty spaces 22 are formed which is composed of grooves. The empty space 22 is formed by a cut surface 21 over the side surface 20 and the lower surface of the frame 3. The empty space 22 formed by the cut surface 21 is shaped into a quarter-circle in cross section, but may be shaped into a different shape such as a triangle or a rectangle in cross section as log as the insulating distance can be maintained.

In the empty space 22 formed by the cut surface 21 at a corner portion over the side surface 20 and the lower surface of the frame 3, a coating material 23 is filled. The coating material 23 is composed of an insulating material, but as later described in the other embodiment, may be composed of a conducting material when the coating material 23 is formed on the cut surface 21 in a predetermined thickness without filling the empty space 22. Moreover, the cut surface 21 may be exposed without being coated.

The frame 3 is fixed to the circuit board 2 with an adhesive 25 so that its lower surface makes direct contact with the nonpolar electrode 4. On the outer circumference portion of the upper surface of the circuit board 2, a depression is formed for arranging the adhesive 25 in almost the same plane as the upper surface of the nonpolar electrode 4. The adhesive 25 is stored in this depression, which permits preventing direct contact between the frame 3 and the circuit board 2 from being hindered by the thickness of the adhesive 25. The lower surface side of the depression for arranging the adhesive 25 is covered by an insulating layer 24 such as insulating resin.

For the electrodes 4, 5, 6, 15, 16, and 17 of the surface-mounted LED 1 configured in this manner, metal or alloy with favorable conductivity and heat radiation performance, such as Cu, Fe, Al, or the like is used. Moreover, it is preferable that surfaces of the electrodes 4, 5, 6, 15, 16 and 17 be plated with Ni, Au, Ag, Pd, Sn, or plated with these superimposed plurally. Furthermore, for the thin metal wires 8 and 9 electrically connecting together the respective electrodes of the LED elements 7 and the electrodes 5 and 6, Ag, Au, Al, or the like is used.

In the surface-mounted LED 1 with the above configuration, application of a predetermined voltage to the polar electrodes 5 and 6 through the terminal sections of the electrodes 16 adn17 causes current flow to the LED elements 7 through the thin metal wires 8 and 9. As a result, the LED elements 7 emit light on their unique wavelength. The light emitted from the LED elements 7 is extracted to the outside through the transmissive resin 11.

A plurality of LED elements 7 are provided, and thus light-emitting diodes for three primary colors, i.e., red, green, and blue can be used. Instead of these, light-emitting diodes for two colors or a light-emitting diode for a single color may be used, or light emitting diodes for four or more colors can also be used. When the LED elements 7 have a plurality of colors and they emit light simultaneously, the different colors are mixed together and extracted to the outside through the transmissive resin 11.

The upper surface of the transmissive resin 11 may be partially notched or another member may be added to the upper surface to thereby form the upper surface into a shape of a semicircular column or hemisphere. This condenses the light emitted from the LED elements 7 and further improves efficiency of upward light emission.

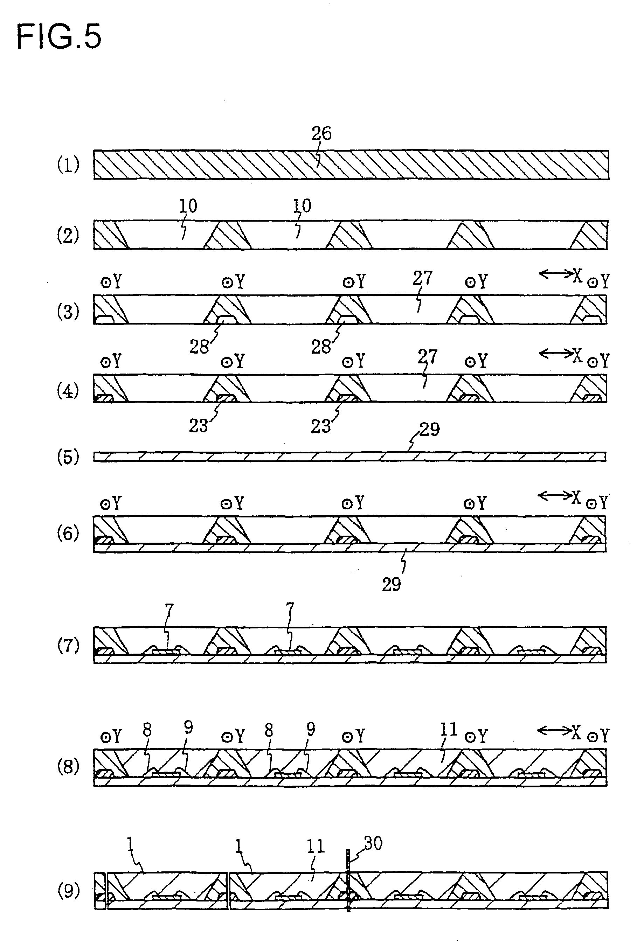

FIGS. 5(1) to (9) are flow diagrams showing representative processes of manufacturing the surface-mounted LED 1. Here, structure of the circuit board 2 and the frame 3 are partially omitted and thus simply expressed. In the first process shown in FIG. 5(1), an aluminum thin plate 26 is supplied. The thickness of the aluminum thin plate 26 is selected from among ranges 0.5 mm to 2 mm or 0.5 mm to 3 mm.

In the second process shown in FIG. 5(2), in the thin plate 26 of aluminum, a plurality of bowl-shaped openings 10 are formed in a matrix form in X and Y directions in such a manner as to penetrate vertically through the thin plate 26 (see FIG. 1). The opening 10 can be formed by etching, drilling, or the like. The aluminum thin plate 26 formed with the openings 10 forms a frame aggregate 27 which is formed with a plurality of frames 3 (see FIG. 1).

The frame aggregate 27 is, as described later, cut along an expected X-direction cut line and an expected Y-direction cut line which crosses the X direction at a predetermined angle. In the above example, the direction parallel to the paper surface of FIG. 5 is defined as the X direction, and the direction orthogonal to the paper surface is defined as the Y direction (the expected Y-direction cut line is shown by a symbol including a dot at the circle center in the figure).

In the third process shown in FIG. 5(3), on the lower surface of the aluminum thin plate 26 formed with the openings 10, grooves 28 in line with the expected Y-direction cut line are formed in a predetermined depth. The grooves 28 are wider than a cut width to be described later. The groove 28 can be formed by any of a variety of known methods, such as chemical processing through etching and machining with a dicing saw. The depth of the groove 28 may be in any depth as long as it does not penetrate through the thin plate 26.

In the fourth process shown in FIG. 5(4), the coating material 23 is filled in the grooves 28 formed in the third process. To completely cover the grooves 28, an insulating material such as resist is used as the coating material 23.

In the fifth process shown in FIG. 5 (5), a circuit board aggregate 29 is supplied. By cutting this circuit board aggregate 29 along the expected X and Y direction cut lines, a plurality of circuit boards 2 (see FIG. 1) are formed.

In the sixth process shown in FIG. 5(6), the frame aggregate 27 and the circuit board aggregate 29 are fixed with the expected cut lines in line. The fixation of the frame aggregate 27 and the circuit board aggregate 29 is performed with the insulating adhesive 25. For a portion where no insulation is required, the fixation may be done by using a conductive jointing material such as a conductive adhesive or solder, or other fixing means may be used.

In the seventh process shown in FIG. 5 (7), the LED elements 7 are loaded on the circuit board aggregate 29 and wiring of the thin metal wires 8 and 9 are performed through wire bonding.

In the eighth process shown in FIG. 5 (8), the transmissive resin 11, which transmits light, is filled in the openings 10 so that the LED elements 7 and the thin metal wires 8 and 9 are embeded, thereby hardening the transmissive resin 11.

In the ninth process shown in FIG. 5 (9), the frame aggregate 27 and the circuit board aggregate 29 are cut along the expected X-direction and Y-direction cut lines by using a dicing saw 30. As a result, a plurality of surface-mounted LEDs 1 are obtained separately.

In this manner, the surface-mounted LED 1 as the electronic component shown in FIGS. 1 and 4 described above is manufactured. The surface-mounted LED is formed with an upper surface thereof sized several millimeters square and with a thickness of approximately 0.3 to 3 mm. Four side surfaces of this surface-mounted LED 1 is cut simultaneously with the dicing saw 30; therefore, the circuit board 2 and the frame 3 fixed thereto have four side surfaces 41 (common side surfaces) composed of the same surface.

To individually cut the frames 3 and the LED elements 7 arrayed in line with the dicing saw 30, opposing two side surfaces are cut simultaneously with the dicing saw 30. Therefore, the circuit board 2 and the frame 3 fixed thereto have two opposing side surfaces (common side surfaces) formed of the same surface.

In the ninth process of cutting with the dicing saw 30, the side surface of the surface-mounted LED 1 on the side on which the terminal sections connected to the polar electrodes 5 and 6 are drawn is formed. At this point, metal burr may be formed as a result of cutting along the lower edge of the cut surface of the metallic frame 3 (side surface 20 of the frame 3). However, the presence of the empty space 22 created by the grooves 28 formed in the third process ensures a predetermined distance between the frame 3 and the circuit board 2. This therefore previously avoids the metal burr from making contact with the terminal sections connected to the electrodes 5 and 6 of the circuit board 2.

Although the insulation distance between the frame 3 and the circuit board 2 can be ensured with the empty space 22 only, filling the insulating coating material 23 in the empty space 22 enhances the insulation and also suppresses occurrence of metal burr. The insulating coating material 23 may be applied to the empty space 22. Moreover, on the upper surface of the circuit board 2 facing the empty space 22, the insulating layer 24 is formed, and the insulating adhesive 25 is located further thereon. Thus, the effect of the metal burr can be more reliably eliminated.

Moreover, the terminals connected to the polar electrodes 5 and 6 of the circuit board 2 are arranged on the lower surface of the circuit board 2. Thus, the lower surface of the frame 3 and the terminals can be arranged furtherer away from each other to avoid the risk of contact of the metal burr. Further, since the region where the frame 3 on the upper surface of the circuit board 2 is loaded serves as the electrode 4, even when the metal burr makes contact with the upper surface of the circuit board 2, there is almost no effect on the circuit.

Heat generated at the LED elements 7 is effectively radiated on the upper and lower surfaces of the circuit board 2. First, on the upper surface of the circuit board 2, the heat is radiated over a wide range by the non-polar electrode 4 and the metal frame 3 directly making contact with the electrode 4. On the lower surface of the circuit board 2, the heat is radiated over a wide range through the electrode 15 directly connected through the through hole 13 of the insulating substrate to the electrode 4.

As shown in FIG. 4, the electrode 15 for heat radiation formed on the lower surface of the surface-mounted LED 1 extends from the central part of the lower surface to its both side ends, occupying a wide area. The area of the electrode 15 for heat radiation is wider than a total area of the electrodes 16 and 17 which are connected to the electrodes 5 and 6 having positive and negative polarities and which are located on the lower surface.

The frame 3 includes an inner circumference surface widening upward around the opening 10. Light emitted from the LED element 7 is reflected by the inner circumference surface of the frame 3. Therefore, the inner circumference surface of the frame 3 functions as a reflective surface, and can improve the light use efficiency.

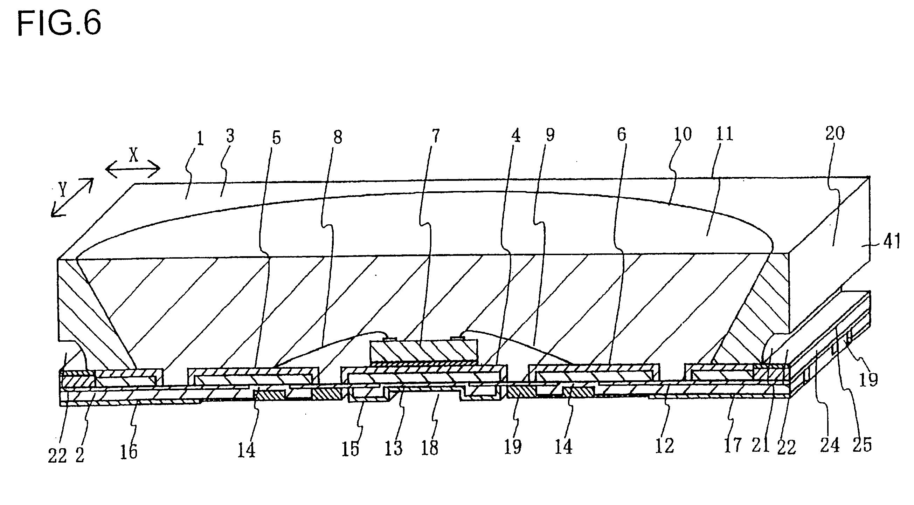

Next, FIG. 6 is a perspective view showing a surface-mounted LED 1 as an electronic component of the second embodiment. For explanatory purposes, portions the same as those in the first embodiment shown in FIGS. 1 to 4 described above are provided with the same numerals. This embodiment is different from the first embodiment in that the coating material 23 (see FIG. 1) filled in the empty space 22 is omitted. This embodiment is the same as the first embodiment in other configuration.

This embodiment can be carried out by omitting the resin filling process as the fourth process in the manufacturing processes of the surface-mounted LED 1 shown in FIG. 5 described above. Since the coating material 23 is omitted, the insulation performance deteriorates compared to the first embodiment, but good practicability can be achieved by ensuring the insulation distance between the frame 3 and the circuit board 2 by the empty space 22.

At the time of forming the grooves 28 in the third process of FIG. 5 described above, the depth of the grooves 28 may be made smaller than the thickness of the circuit board 2. However, making the depth of the grooves 28 larger than or equal to the thickness of the circuit board 2 is preferable since it improves the insulation performance. Moreover, the depth of the grooves 28 may be set at such a depth that does not permit penetration of the frame 3. When the circuit board 2 is fixed at a section where soldering paste is applied by using a metal mask or the like, the depth of the grooves 28 may be set so that it becomes higher (deeper) than the thickness (height) of this soldering paste. This can avoid effect of soldering, which is more preferable.

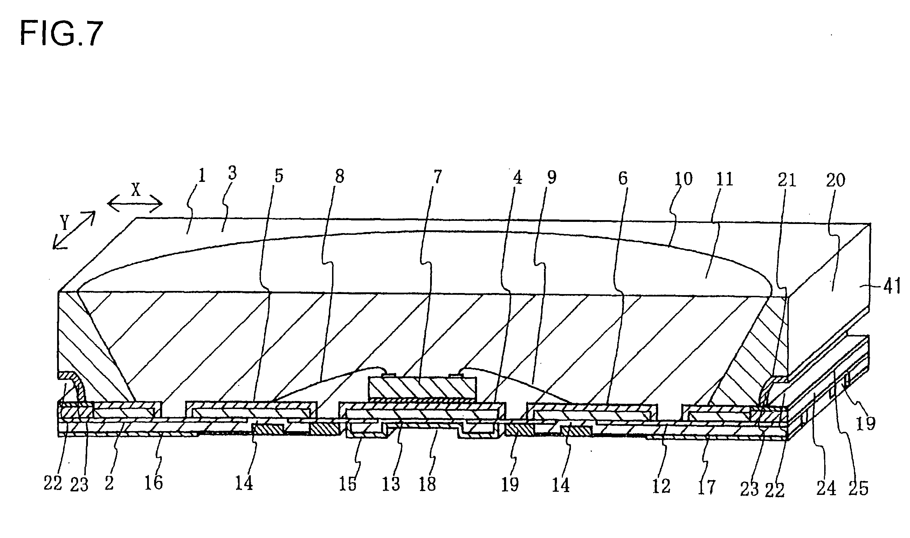

Next, FIG. 7 is a perspective view showing a surface-mounted LED 1 as an electronic component of the third embodiment. For explanatory purposes, portions the same as those in the first embodiment shown in FIGS. 1 to 4 described above are provided with the same numerals. This embodiment is different from the first embodiment in that the coating material 23 (see FIG. 1) filled in the empty space 22 is a coating layer of a predetermined thickness. This embodiment is the same as the first embodiment in other configuration.

Since the insulation distance can be ensured with the empty space 22 and the coating material 23, the insulation performance equivalent to that of the first embodiment can be ensured. The coating material 23 may be an insulating material as is the case with the first embodiment, or may be a conducting material.

Using a harder material for the coating material 23 than a material forming the frame 3 is preferable since it suppresses occurrence of burr. When a conducting material is used as the coating material 23, a metal material capable of preventing the occurrence of metal burr in the frame 3 can be used. As such a metal material, a hard metal material of nickel, chrome, titanium, or the like can be used.

Moreover, when a main material of the frame 3 is formed of aluminum, magnesium, or the like, the surface of the frame 3 may be subjected to chemical conversion treatment (alumite treatment) to form the coating material 23 composed of an insulating body. For example, when the frame 3 is of aluminum, the Vickers hardness (Hv) after typical alumite treatment is 200 to 250, and the Vickers hardness (Hv) after hard alumite treatment is 400 to 450. Therefore, the alumite portion can be used as the coating material 23.

Moreover, the typical film thickness of alumite is approximately 20 µm, but can be thickened to approximately 100 µm. Thus, the use of thick-filmed alumite as the coating material 23 can improve effect of insulation and effect of preventing metal burr.

In the first to third embodiments, the electronic components using a plurality of LED elements 7 have been described, although the invention is also applicable to others. For example, it is also applicable to an electronic component composed of a surface-mounted LED using only one LED element 7. Moreover, the invention is also applicable to an electronic component having as a heat-generating element a circuit element which has resistance components such as a chip resistor, an IC, etc. in addition to the LED element

### Industrial Applicability

According to the present invention, the invention can be used for an electronic component having a frame fixed on the upper surface of a circuit board and for a method for manufacturing same. More specifically, the invention is applicable to a surface-mounted LED used as a light source for switch inner illumination, an LED display, a backlight light source, an optical printer head, a camera flash, or the like.

## Claims

1. An electronic component having a frame which is composed of a conductor and which is fixed on a circumference portion on an upper surface of a circuit board, wherein the circuit board and the frame have a side surface composed of a same surface,
wherein the circuit board has a terminal section exposed on the side surface, and
wherein the frame has an empty space over a lower surface facing the circuit board and the side surface.

2. The electronic component according to claim 1,
wherein the terminal section is formed on a surface of the circuit board on a side separated from the frame.

3. The electronic component according to either of claims 1 and 2,
wherein a coating material composed of an insulating body is filled in the empty space.

4. The electronic component according to either of claims 1 and 2,
wherein the frame has a surface facing the empty space, the surface being covered by a coating material having a higher degree of hardness than the frame and a predetermined thickness.

5. The electronic component according to claim 4,
wherein the coating material is formed by subjecting the frame to chemical conversion treatment.

6. The electronic component according to claim 1, comprising a surface-mounted LED having an LED element arranged inside surrounded by the frame, the surface-mounted LED reflecting emitted light of the LED element by the frame.

7. A method for manufacturing an electronic component, the method comprising: a process of supplying a circuit board aggregate where a plurality of circuit boards having a terminal section of an electrode are formed;
a process of forming a frame aggregate having a plurality of frames;
a process of fixing the circuit board aggregate and the frame aggregate;
and a process of cutting and dividing the fixed circuit board aggregate and frame aggregate on the frames and the terminal sections,
wherein a process of forming, on a side of the frame facing the circuit board aggregate, a groove extending along cut surfaces of the circuit board aggregate and the frame aggregate and having a wider width than a cutting width is provided before the process of fixing the circuit board aggregate and the frame aggregate.

8. The method for manufacturing an electronic component according to claim 7, further comprising a process of filling in the groove a coating material composed of an insulating body.

9. The method for manufacturing an electronic component according to claim 7, further comprising a process of covering a surface of the groove with a coating material having a higher degree of hardness than the frame and a predetermined thickness.
